# EUROPEAN PATENT APPLICATION

(11) **EP 4 492 179 A1**
(43) Date of publication of application: **15.01.2025**
(21) Application number: 23819471.6
(22) Date of filing: 30.03.2023
(51) Int. Cl.: G05D 1/02

(54) **CONVEYANCE SYSTEM**

(30) Priority: 06.06.2022 JP 2022091671
(71) Applicant: Murata Machinery, Ltd., Kyoto-shi, Kyoto 601-8326 (JP)
(72) Inventor: ITO Naohisa, Inuyama-shi, Aichi 484-8502 (JP); AOKI Eijiro, Inuyama-shi, Aichi 484-8502 (JP)
(74) Representative: Hoffmann Eitle
(86) International application number: PCT/JP2023/013322
(87) International publication number: WO 2023/238484

(57) **Abstract**

A transport system includes a plurality of transport vehicles configured to travel along a track and transport a load and a controller. The track has a first main track and a plurality of branch tracks connecting to the first main track via confluence points different from each other. The controller executes departure control that causes the transport vehicles stopped at respective stop positions of the branch tracks to depart toward the first main track for each of the branch tracks. The departure control prohibits, in accordance with whether the transport vehicle is present in a certain section on the track, departure of at least one of the transport vehicles stopped at the respective stop positions of the branch tracks.

## Description

### Technical Field

One aspect of the present invention relates to a transport system.

### Background Art

A transport system including a plurality of transport vehicles traveling along a track and a controller configured to control the traveling of the transport vehicles is known. As technology related to such a transport system, for example, Patent Literature 1 describes a system in which transport vehicles stopped at respective stop positions of a plurality of branch tracks of the track are caused to depart at a timing according to the count of a pitch timer for each of the branch tracks.

### Citation List

### Patent Literature

Patent Literature 1: Japanese Patent No. 6935846

### Summary of Invention

### Technical Problem

In the transport system described above, for some reason, there may arise an excess or shortage of the transport vehicles present in a certain section on the track. In this case, for example, due to a shortage of the transport vehicles, the time during which a transport vehicle can be stopped at a stop position corresponding to a loading port may be reduced on a particular branch track, and the transport vehicle may depart without being able to be loaded. In addition, for example, due to a concentration of the transport vehicles, the departure of a transport vehicle may be blocked by a preceding transport vehicle, resulting in congestion. Consequently, it becomes difficult to smoothly transport loads by the transport vehicles.

One aspect of the present invention has been made in view of the above circumstances, and an object thereof is to provide a transport system in which transport vehicles can smoothly transport loads.

### Solution to Problem

A transport system according to one aspect of the present invention is a transport system including a plurality of transport vehicles configured to travel along a track and transport a load and a controller configured to control traveling of the transport vehicles, the track having a first main track and a plurality of branch tracks connecting to the first main track via confluence points different from each other, the controller executing departure control that causes the transport vehicles stopped at respective stop positions of the branch tracks to depart toward the first main track for each of the branch tracks, and the departure control prohibiting, in accordance with whether the transport vehicle is present in a certain section on the track, departure of at least one of the transport vehicles stopped at the respective stop positions of the branch tracks.

In this transport system, the transport vehicles stopped at the stop positions of the branch tracks depart for each branch track, and the departure of at least one of them is prohibited in accordance with an excess or shortage of the transport vehicles in the certain section on the track. This prevents transport from being congested due to a shortage and concentration of the transport vehicles and enables the transport vehicles to smoothly transport the load.

In the transport system according to one aspect of the present invention, the track may have a second main track, the stop positions may correspond to loading ports for loading the transport vehicles, the second main track may branch off to the branch tracks via branch points different from each other, the certain section may include a first section, which is a section upstream of the stop position in each of the branch tracks, and the departure control may prohibit departure of the transport vehicle stopped at the stop position of one of the branch tracks when the transport vehicle is not present in the first section of one of the branch tracks and the transport vehicle scheduled to enter the first section from the second main track is not present. With this, even when there is a shortage of the transport vehicles in one of the branch tracks, the transport vehicle can be stopped at the stop position for a sufficient amount of time, and the transport vehicle can be surely loaded during that time. That is, it is possible to prevent the transport vehicle from departing without being able to be loaded in one of the branch tracks.

In the transport system according to one aspect of the present invention, in the first section, an unloading port for unloading the load from the transport vehicle may be disposed along the track, and the departure control may prohibit departure of the transport vehicle stopped at the stop position of one of the branch tracks when the transport vehicle having already unloaded to the unloading port is not present in the first section of one of the branch tracks. In this case, it is possible to surely prevent the transport vehicle from departing without being able to be loaded in one of the branch tracks.

In the transport system according to one aspect of the present invention, the certain section may include a second section, which is a section to the confluence point most downstream from the stop positions of the branch tracks in the track, and the departure control may prohibit departure of all the transport vehicles stopped at the respective stop positions of the branch tracks when another transport vehicle other than the transport vehicles is present in the second section. In this case, in the second section, congestion due to a concentration of the transport vehicles can be prevented from occurring.

In the transport system according to one aspect of the present invention, the departure control may cause the transport vehicles stopped at the respective stop positions of the branch tracks to depart at a timing repeated at a fixed cycle for each of the branch tracks and, for the transport vehicle the departure in a certain cycle of which has been prohibited, may determine again whether departure in the next cycle is prohibited. In this case, the above effect, that is, causing each transport vehicle to depart in accordance with an excess or shortage of the transport vehicles can be specifically achieved while improving the efficiency in transporting the load by causing each stopped transport vehicle to depart at a timing at a fixed cycle.

In the transport system according to one aspect of the present invention, the departure control, for the transport vehicle the departure of which has been prohibited over certain cycles, may permit departure in the next cycle. In this case, it is possible to avoid the transport vehicle the departure of which has been prohibited in the departure control from not transporting the load for a long period of time.

### Advantageous Effects of Invention

One aspect of the present invention can provide a transport system capable of improving the efficiency in transporting the load.

### Brief Description of Drawings

[FIG. 1] FIG. 1 is a schematic plan view illustrating a transport system according to an embodiment.
[FIG. 2] FIG. 2 is a side view illustrating a transport vehicle of the transport system in FIG. 1.
[FIG. 3] FIG. 3 is a schematic plan view illustrating a first building side of the transport system in FIG. 1.
[FIG. 4] FIG. 4 is a schematic plan view illustrating an example of departure control when the transport vehicle is not present in a first section in the transport system in FIG. 1.
[FIG. 5] FIG. 5 is a schematic plan view illustrating an example of the departure control when the transport vehicle is present in a second section in the transport system in FIG. 1.

### Description of Embodiments

One embodiment will now be described with reference to the attached drawings. In description of the drawings, like or equivalent elements are designated by like reference signs, and duplicate description is omitted. The dimensional proportions in the drawings do not necessarily match those in the description.

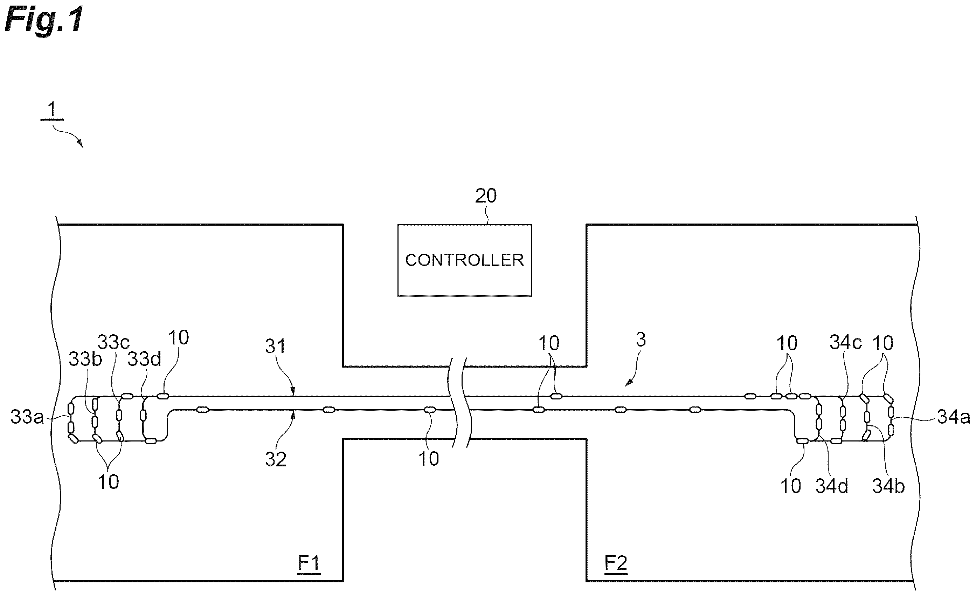

As illustrated in FIG. 1, this transport system 1 is a system configured to perform transport between two points in which a transport source and a transport destination are patterned. The transport system 1 performs inter-building transport, which performs delivery of loads between a first building F1 and a second building F2. The transport system 1 includes a plurality of transport vehicles 10 and a controller 20. The transport vehicles 10 travel along a track 3 to transport loads. The transport vehicles 10 are configured to be capable of transferring loads. The transport vehicles 10 are Overhead Hoist Transports. The transport vehicles 10 are also referred to as, for example, vehicles (transport vehicles), overhead traveling vehicles (overhead transport vehicles), or traveling vehicles (traveling carts). The number of the transport vehicles 10 included in the transport system 1 is, for example, about 50 and varies depending on the amount of transport demand and a transport distance.

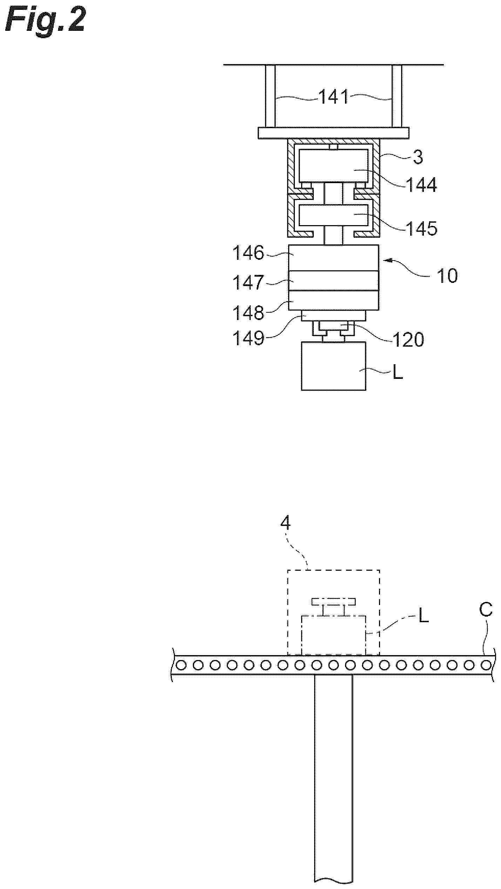

As illustrated in FIG. 2, the transport vehicle 10 includes a traveling cart 144, a power supply cart 145 configured to receive power supply from the track 3, a θ drive 147, and a laterally feeding unit 146 for laterally feeding the lower portion thereof with respect to the track 3. The θ drive 147 turns a lifting and lowering drive unit 148 in a horizontal plane to control the attitude of a load L. The lifting and lowering drive unit 148 lifts and lowers a lifting and lowering platform 149, which grasps the load L, and delivers the load L to and from a delivery port 4. The lifting and lowering platform 149 grasps the portion of a flange 124 as the upper part of the load L. The laterally feeding unit 146 and the θ drive 147 are not necessarily required to be provided. The load L is, for example, a container storing a plurality of semiconductor wafers, but it may also be a glass substrate, a general component, or the like.

The track 3 is laid on, for example, the ceiling or the like. The track 3 is supported by columns 141. The track 3 is a traveling path set in advance for causing the transport vehicles 10 to travel. The track 3 is a one-way traveling path. In other words, in the transport system 1, a traveling direction (a forward direction) of the transport vehicles 10 on the track 3 is set to one direction, and traveling in the opposite direction is prohibited. The track 3 has a closed track layout that is not affected from outside the track 3. In the following, the terms "upstream" and "downstream" correspond to "upstream" and "downstream," respectively, in the traveling direction of the transport vehicles 10.

In the example illustrated in FIG. 1, the track 3 includes main tracks 31 and 32, four first branch tracks 33a, 33b, 33c, and 33d branching off from the main track 32 and joining the main track 31, and four second branch tracks 34a, 34b, 34c, and 34d branching off from the main track 31 and joining the main track 32. The main tracks 31 and 32 are tracks connecting between a first building F1 and a second building F2. The length of the main tracks 31 and 32 is, for example, 200 m. Between the first building F1 and the second building F2, the main tracks 31 and 32 are enclosed surrounded by a wall portion (not illustrated). The main track 31 and 32, the first branch tracks 33a to 33d, and the second branch tracks 34a to 34d form circling tracks for causing the transport vehicles 10 to travel in a circling manner.

The first branch tracks 33a to 33d are disposed inside the first building F1. The first branch tracks 33a to 33d extend in parallel to each other. The first branch tracks 33a to 33d are provided in a comb-like manner between the main tracks 31 and 32 extending in parallel to each other. The first branch tracks 33a to 33d are positioned upstream of the main track 31 (downstream of the main track 32) in this order. The second branch tracks 34a to 34d are disposed in the second building F2. The second branch tracks 34a to 34d extend in parallel to each other. The second branch tracks 34a to 34d are provided in a comb-like manner between the main tracks 31 and 32 extending in parallel to each other. The second branch tracks 34a to 34d are positioned upstream of the main track 32 (downstream of the main track 31) in this order.

The following specifically describes the configuration and control of the transport system 1. In the following description, the configuration and control of the first building F1 will be described, and descriptions of the configuration and control of the second building F2 will be omitted as appropriate because they are similar.

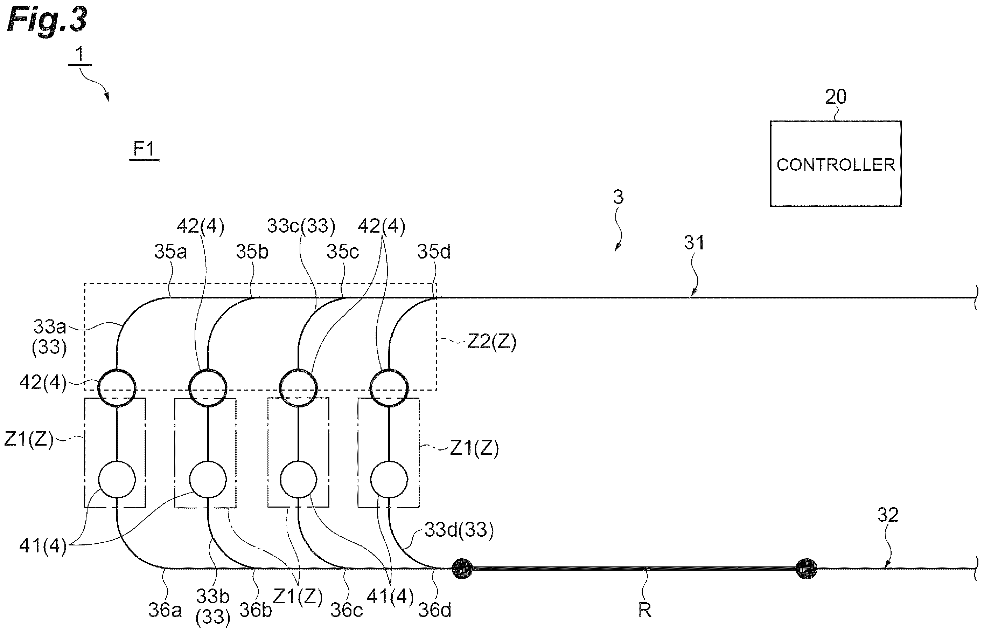

As illustrated in FIG. 3, points at which the first branch tracks 33a to 33d join the main track 31 are confluence points 35a, 35b, 35c, and 35d. Each of the first branch tracks 33a to 33d connects to the main track 31 via each of the confluence points 35a, 35b, 35c, and 35d. That is, the track 3 has the confluence points 35a to 35d, which are a plurality of confluence points disposed spaced apart from each other on the main track 31. The main track 31 is joined from each of the first branch tracks 33a to 33d via the confluence points 35a, 35b, 35c, and 35d different from each other. For example, it is regarded that the portion of the track 3 downstream of the confluence point 35a is the main track 31, which is joined from the first branch track 33a upstream thereof. The first branch tracks 33a to 33d each connect to the main track 31 via the confluence points 35a to 35d different from each other. The confluence points 35a to 35d are separated from each other by a certain distance on the main track 31.

Points at which the first branch tracks 33a to 33d branch off from the main track 32 are branch points 36a, 36b, 36c, and 36d. Each of the first branch tracks 33a to 33d connects to the main track 32 via each of the branch points 36a, 36b, 36c, and 36d. In other words, the track 3 has the branch points 36a to 36d, which are a plurality of branch points disposed spaced apart from each other on the main track 32. The main track 32 branches off to each of the first branch tracks 33a to 33d via the branch points 36a, 36b, 36c, and 36d different from each other. For example, it is regarded that the portion of the track 3 upstream of the branch point 36a is the main track 32, which branches off to the first branch track 33a downstream thereof. The first branch tracks 33a to 33d each connect to the main track 32 via the branch points 36a to 36d different from each other. The branch points 36a to 36d are separated from each other by a certain distance on the main track 32.

The "confluence point" is a point at which a branch track connects to a main track. The "confluence point" is a point at which the branch track leads to the main track. The "confluence point" is a connecting point of the branch track and the main track for allowing entry to the main track from the branch track. The "branch point" is a point at which the main track connects to the branch track. The "branch point" is a point at which the main track leads to the branch track. The "branch point" is a connecting point of the main track and the branch track for allowing entry to the branch track from the main track. In the example illustrated in FIG. 3, the main track 31 corresponds to a first main track, the main track 32 corresponds to a second main track, and the first branch tracks 33a to 33d correspond to branch tracks.

Each of the first branch tracks 33a to 33d has a stop position corresponding to the delivery port 4 for the transport vehicle 10 to deliver the load L. The delivery port 4 is disposed along each of the first branch tracks 33a to 33d. The delivery port 4 is provided, for example, on a conveyor (not illustrated) transporting the load L. The delivery port 4 has an unloading port 41 and a loading port 42.

The unloading port 41 is a port for unloading the load L from the transport vehicle 10. At the unloading port 41, after the load L is placed, the load L is removed before the subsequent transport vehicle 10 arrives. The unloading port 41 is disposed upstream of the loading port 42 with a certain gap. In other words, the loading port 42 is disposed downstream of the unloading port 41 with a certain gap. The loading port 42 is a port for loading the load L onto the transport vehicle 10. The loading port 42 can bring in the load L into the port in a span of consecutive arrivals of the transport vehicles 10. As the unloading port 41 and the loading port 42, there are no particular limitations, and various known ports can be employed.

As illustrated in FIG. 3, the controller 20 is an electronic control unit constituted by a central processing unit (CPU), a read only memory (ROM), a random access memory (RAM), and the like. The controller 20 can be configured as software in which, for example, a program stored in the ROM is loaded onto the RAM and is executed by the CPU. The controller 20 may be configured as hardware including electronic circuitry or the like. The controller 20 communicates with the transport vehicles 10 and controls the traveling of the transport vehicles 10.

The controller 20 executes departure control that causes the transport vehicles 10 stopped at stop positions corresponding to the respective delivery ports 4 of the first branch tracks 33a to 33d (in this case, stop positions corresponding to the loading ports 42) to depart toward the main track 31 for each of the first branch tracks 33a to 33d. In the following, the stop position corresponding to the loading port 42 may also be referred to simply as the "stop position". The upstream and downstream of the departure control correspond to the upstream and downstream of the main track 31, and the upstream and downstream of the entry control correspond to the upstream and downstream of the main track 32.

The departure control causes the transport vehicle 10 stopped on the downstream first branch track among the first branch tracks 33a to 33d to depart at the same time as or earlier than the transport vehicle 10 stopped on the upstream first branch track. Specifically, the departure control causes the transport vehicle 10 stopped on the first branch track 33d to depart at the same time as or earlier than the transport vehicle 10 stopped on the first branch track 33c. The departure control causes the transport vehicle 10 stopped on the first branch track 33c to depart at the same time as or earlier than the transport vehicle 10 stopped on the first branch track 33b. The departure control causes the transport vehicle 10 stopped on the first branch track 33b to depart at the same time as or earlier than the transport vehicle 10 stopped on the first branch track 33a.

More specifically, the departure control causes each of the stopped transport vehicles 10 to depart (forcedly depart) regardless of whether the load L is loaded at a timing repeated at a fixed cycle for each of the first branch tracks 33a to 33d. For example, the departure control starts counting down from a standard pitch time by a pitch timer in each of the first branch tracks 33a to 33d. When the count of the pitch timer reaches 0, the transport vehicle 10 stopped at the stop position is caused to depart, and the count of the pitch timer is reset to the standard pitch time. The counting down is then continued by the pitch timer. The standard pitch time may be a fixed value set in advance or a variable value. In the present embodiment, the time axes of the pitch timers for the respective first branch tracks 33a to 33d are shifted so that the transport vehicle 10 stopped on the downstream first branch track departs first.

The controller 20 executes the entry control configured to cause each of the transport vehicles 10 traveling on the main track 32 to successively enter each of the first branch tracks 33a to 33d in the order from downstream to upstream. Specifically, in the entry control, the transport vehicle 10 is caused to enter the first branch track 33a, the next transport vehicle 10 is caused to enter the first branch track 33b, the next transport vehicle 10 is caused to enter the first branch track 33c, the next transport vehicle 10 is caused to enter the first branch track 33d, and then such entry of the transport vehicle 10 is repeated.

In the entry control, transport destination determination control to determine (guide) a transport destination is performed for the transport vehicle 10 traveling through a specific section R upstream of the branch points 36a to 36d in the main track 32. The specific section R is a straight section close to the branch points 36a to 36d. The specific section R is not limited to a particular section so long as it is upstream of the branch points 36a to 36d. The specific section R is not limited to a straight section, but may be a section including a curve, and may be various sections. The transport destination determination control determines the delivery port 4 as the transport determination (in this case, the unloading port 41 of any of the first branch tracks 33a to 33d) .

The controller 20 grasps the number (the entry number) of the transport vehicles 10 present on each of the first branch tracks 33a to 33d. Specifically, in the entry control, at a timing when the transport destination is determined by the transport destination determination control described above, the controller 20 increases (counts up) the number of the transport vehicles 10 present on any of the first branch tracks 33a to 33d corresponding to the transport destination by one. When causing the transport vehicle 10 stopped at the stop position of any of the first branch tracks 33a to 33d to depart in the departure control, the controller 20 reduces (counts down) the number of the transport vehicles 10 present on any of the first branch tracks 33a to 33d by one at a timing of the departure.

Referring back to FIG. 1, the controller 20 executes virtual coupling control to perform the departure control and the entry control described above for each group of transport vehicles including a plurality of (four in this case) transport vehicles 10 corresponding to the number of the first branch tracks 33a to 33d. The controller 20 causes the transport vehicles 10 to travel along the circling tracks (the main tracks 31 and 32, the first branch tracks 33a to 33d, and the second branch tracks 34a to 34d) such that their circling distances or circling times are the same. Specifically, in the entry control, the controller 20 causes the transport vehicle 10 having been caused to enter the first branch track 33d to enter the second branch track 34a, causes the transport vehicle 10 having been caused to enter the first branch track 33c to enter the second branch track 34b, causes the transport vehicle 10 having been caused to enter the first branch track 33b to enter the second branch track 34c, and causes the transport vehicle 10 having been caused to enter the first branch track 33a to enter the second branch track 34d. In the entry control, the controller 20 causes the transport vehicle 10 having been caused to enter the second branch track 34d to enter the first branch track 33a, causes the transport vehicle 10 having been caused to enter the second branch track 34c to enter the first branch track 33b, causes the transport vehicle 10 having been caused to enter the second branch track 34b to enter the first branch track 33c, and causes the transport vehicle 10 having been caused to enter the second branch track 34a to enter the first branch track 33d.

The departure control of the present embodiment prohibits, in accordance with whether the transport vehicle 10 is present in a certain section Z on the track 3, the departure of at least one of the transport vehicles 10 stopped at the stop positions corresponding to the respective loading ports 42 of the first branch tracks 33a to 33d. For example, the presence of the transport vehicle 10 in the certain section Z includes the presence of a standard position as a standard of the position of the transport vehicle 10 (such as the central position of the transport vehicle 10) within the certain section Z. For example, the presence of the transport vehicle 10 in the certain section Z includes the transport vehicle 10 being actually present and being scheduled to be present.

As illustrated in FIG. 3, the certain section Z includes a first section Z1 and a second section Z2. The first section Z1 is a section upstream of the stop position corresponding to the loading port 42 in each of the first branch tracks 33a to 33d. In the first section Z1, the unloading port 41 is disposed along each of the first branch tracks 33a to 33d. In other words, the first section Z1 includes at least the stop position corresponding to the unloading port 41. The first section Z1 is provided such that the transport vehicle 10 present therein does not physically interfere with the transport vehicle 10 stopped at the stop position corresponding to the loading port 42.

The second section Z2 is a section from the stop positions corresponding to the loading ports 42 of the first branch tracks 33a to 33d to the most downstream confluence point 35d in the track 3. The second section Z2 includes a section downstream of the stop positions corresponding to the loading ports 42 in the respective first branch tracks 33a to 33d and a section from the confluence point 35a to the confluence point 35d in the main track 31. The second section Z2 is also referred to as a gate-closed section. The second section Z2 is provided such that the transport vehicle 10 present therein does not physically interfere with the transport vehicle 10 stopped at the stop position corresponding to the loading port 42.

The departure control prohibits the departure of the transport vehicle 10 stopped at the stop position corresponding to the loading port 42 of one of the branch tracks 33 when the transport vehicle 10 is not present in the first section Z1 of one of the branch tracks 33 and the transport vehicle 10 scheduled to enter the first section Z1 of one of the branch tracks 33 from the main track 32 is not present. One of the branch tracks 33 means any of the first branch tracks 33a to 33d. The transport vehicle 10 scheduled to enter the first section Z1 of one of the branch tracks 33 from the main track 32 is, for example, the transport vehicle 10 traveling through the specific section R, the transport vehicle 10 for which the unloading port 41 along one of the branch tracks 33 having been determined as the transport destination by the transport destination determination control.

For example, the departure control prohibits the departure of the transport vehicle 10 stopped at the stop position of one of the branch tracks 33 when the transport vehicle 10 having already unloaded to the unloading port 41 is not present (not stopped) at the stop position corresponding to the unloading port 41 in the first section Z1 of one of the branch tracks 33.

The departure control prohibits the departure of all the transport vehicles 10 stopped at the stop positions corresponding to the respective loading ports 42 of the first branch tracks 33a to 33d (in other words, a group of transport vehicles to be caused to depart in the departure control in the same cycle) when another transport vehicle 10 other than the transport vehicles 10 is present in the second section Z2. The other transport vehicle 10 may be, for example, the transport vehicle 10 included in a group of transport vehicles having been caused to depart in the departure control in the previous cycle. Whether the other transport vehicle 10 is present in the second section Z2 can be determined by the controller 20, for example, based on the position information of the transport vehicles 10 obtained by periodically performing communication with the transport vehicles 10.

As described above, the departure control causes the transport vehicles 10 stopped at the stop positions corresponding to the respective loading ports 42 of the first branch tracks 33a to 33d to depart at a timing repeated at a fixed cycle for each of the first branch tracks 33a to 33d. The departure control, for the transport vehicle the departure in a certain cycle of which has been prohibited, determines again whether departure in the next cycle is prohibited. The departure control, for the transport vehicle 10 the departure of which has been prohibited over certain cycles, unconditionally permits departure in the next cycle. The certain cycles correspond to n cycles of the pitch timer (n is a set constant, and n = 3, for example).

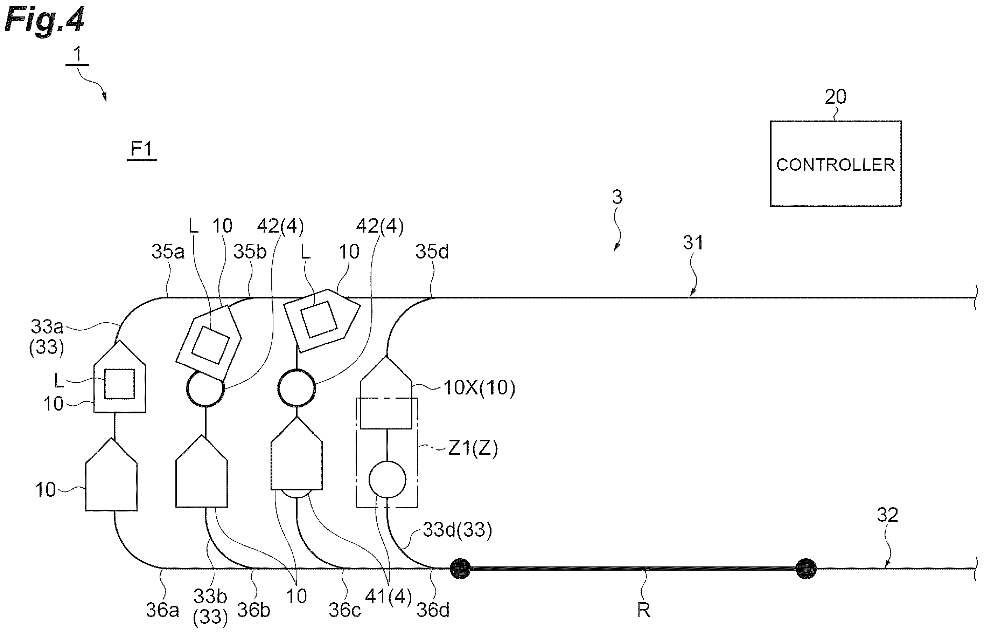

FIG. 4 is a schematic plan view illustrating an example of the departure control when the transport vehicle 10 is not present in the first section Z1 of the first branch track 33d in the transport system 1. In the example in FIG. 4, the transport vehicle 10 scheduled to enter the first section Z1 is not present either. As illustrated in FIG. 4, in the first section Z1 of the first branch track 33d, the transport vehicle 10 having already unloaded to the unloading port 41 is not stopped. In other words, on the first branch track 33d, behind a transport vehicle 10X, which is stopped at the stop position corresponding to the loading port 42, the transport vehicle 10 as an empty transport cart capable of transporting is not prepared. Thus, in this case, the controller 20 will prohibit the departure of the transport vehicle 10X in the current cycle.

For the transport vehicle 10X, in the next cycle, whether its departure is prohibited is determined again. For example, if, in the next cycle, the transport vehicle 10 having already unloaded to the unloading port 41 is stopped behind the transport vehicle 10X, the transport vehicle 10X obtains release from the prohibition of departure and is caused to depart successively in sync with the transport vehicles 10 stopped at the stop positions of the first branch tracks 33a to 33c.

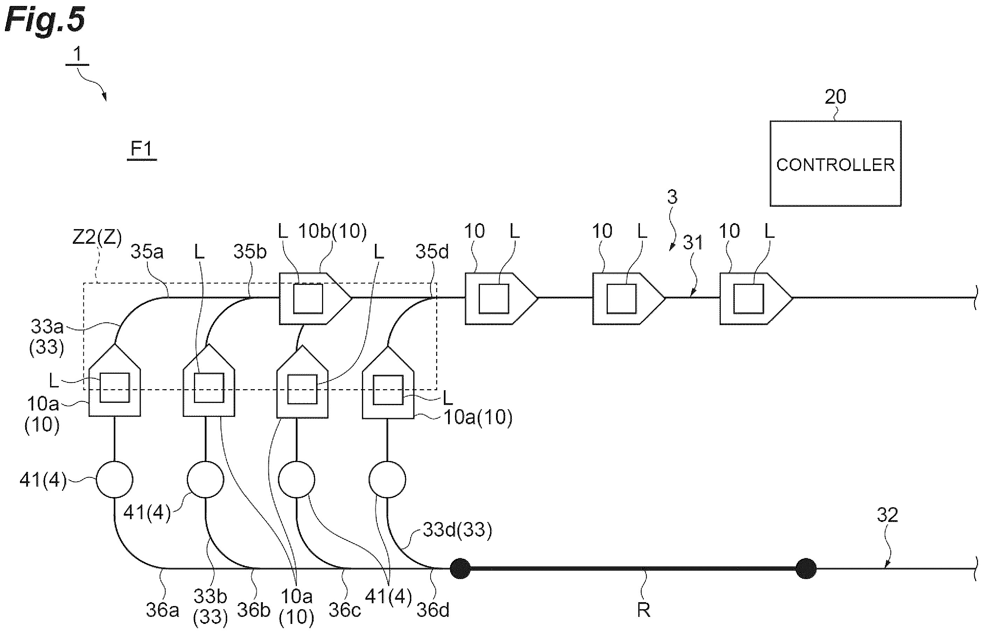

FIG. 5 is a schematic plan view illustrating an example of the departure control when the transport vehicle 10 is present in the second section Z2 in the transport system 1. In the example in FIG. 5, the departure control in the kth cycle causes the transport vehicles 10a stopped at the respective stop positions of the first branch tracks 33a to 33d to successively depart. In this process, a transport vehicle 10b at the rearmost of a group of transport vehicles having been caused to depart by the departure control in the (k-1)th cycle is still present in the second section Z2. Thus, in this case, the controller 20 will cancel the departure control in the kth cycle and prohibit the departure of all the stopped transport vehicles 10a.

As described above, in the transport system 1, the transport vehicles 10 stopped at the stop positions of the first branch tracks 33a to 33d depart for each of the first branch tracks 33a to 33d. Along with this, the departure of at least one of them is prohibited in accordance with an excess or shortage of the transport vehicles 10 in the certain section Z on the track 3. This prevents transport from being congested due to a shortage and concentration of the transport vehicles 10 and enables the transport vehicles 10 to smoothly transport the load L.

In the transport system 1, the certain section Z includes the first section Z1. The departure control prohibits the departure of the transport vehicle 10 stopped at the stop position of one of the branch tracks 33 when the transport vehicle 10 is not present in the first section Z1 of one of the branch tracks 33 and the transport vehicle 10 scheduled to enter the first section Z1 from the main track 32 is not present. With this, even when there is a shortage of the transport vehicles 10 in one of the branch tracks 33, the transport vehicle 10 can be stopped at the stop position for a sufficient amount of time, and the transport vehicle 10 can be surely loaded during that time.

Consequently, it is possible to prevent the transport vehicle 10 from departing (forcedly departing) without being able to be loaded on one of the branch tracks 33. In addition, even if there arises a bias between the number of the transport vehicles 10 traveling in a direction from the first building F1 toward the second building F2 and the number of the transport vehicles 10 traveling in a direction from the second building F2 toward the first building F1, the bias can be automatically eliminated to be balanced. Even if one of the branch tracks 33 with a shortage of the transport vehicles 10 occurs, it is possible to accumulate the transport vehicles 10 on one of the branch tracks 33, eliminating the shortage of the transport vehicles 10 on one of the branch tracks 33.

In the transport system 1, the departure control prohibits the departure of the transport vehicle 10 stopped at the stop position of one of the branch tracks 33 when the transport vehicle 10 having already unloaded to the unloading port 41 is not present in the first section Z1 of one of the branch tracks 33. In this case, for example, when another transport vehicle 10 as an empty cart is not present immediately behind the transport vehicle 10 stopped on one of the branch tracks 33, the departure of the stopped transport vehicle 10 is prohibited, and it is possible to surely prevent the stopped transport vehicle 10 from forcedly departing without being able to be loaded.

In the transport system 1, the certain section Z includes the second section Z2. The departure control prohibits the departure of all the transport vehicles 10 stopped at the respective stop positions of the first branch tracks 33a to 33d when the other transport vehicle 10b other than the transport vehicles 10 is present in the second section Z2. In this case, in the second section Z2 and areas around it, congestion due to a concentration of the transport vehicles 10 can be prevented from occurring.

In the transport system 1, the departure control causes the transport vehicles 10 stopped at the respective stop positions of the first branch tracks 33a to 33d to depart at a timing repeated at a fixed cycle for each of the first branch tracks 33a to 33d and, for the transport vehicle 10 the departure in a certain cycle of which has been prohibited, determines again whether departure in the next cycle is prohibited. In this case, the above effect, that is, causing each transport vehicle 10 to depart in accordance with an excess or shortage of the transport vehicles 10 can be specifically achieved while improving the efficiency in transporting the load L by causing each stopped transport vehicle 10 to depart at a timing at a fixed cycle. In addition, fluctuations in the pace of transport can be reduced.

In the transport system 1, the departure control, for the transport vehicle 10 the departure of which has been prohibited over certain cycles, permits departure in the next cycle. In this case, it is possible to avoid the transport vehicle 10 the departure of which has been prohibited in the departure control from not transporting the load L for a long period of time.

Although one embodiment according to the present invention has been described above, the present invention is not limited to the above-described embodiment, and various modifications can be made within the scope not departing from the gist of the invention.

In the above embodiment, the track 3 includes four first branch tracks 33a to 33d, but the number of the first branch tracks may be two, three, or five or more. Similarly, the track 3 includes four second branch tracks 34a to 34d, but the number of the second branch tracks may be two, three, or five or more.

In the above embodiment, the departure control causes the transport vehicle 10 to forcedly depart at a fixed cycle regardless of whether the load L is loaded but may cause the transport vehicle 10 to depart on the condition that the load L is loaded. In the above embodiment, the transport destination determination control to determine the transport destination of the transport vehicle 10 traveling in the specific section R is executed, but the transport destination determination control is not necessarily required to be executed, and the delivery port 4 as the transport destination may be determined at any timing. In the above embodiment, the virtual coupling control to perform control for each group of transport vehicles including a plurality of transport vehicles 10 is performed, but the virtual coupling control is not necessarily required to be executed.

The following describes the requirements of one aspect of the present invention.

### <Invention 1>

A transport system including:
a plurality of transport vehicles configured to travel along a track and transport a load; and
a controller configured to control traveling of the transport vehicles,
the track having a first main track and a plurality of branch tracks connecting to the first main track via confluence points different from each other,
the controller executing departure control that causes the transport vehicles stopped at respective stop positions of the branch tracks to depart toward the first main track for each of the branch tracks,
the departure control prohibiting, in accordance with whether the transport vehicle is present in a certain section on the track, departure of at least one of the transport vehicles stopped at the respective stop positions of the branch tracks.

### <Invention 2>

The transport system according to Invention 1, in which
the track has a second main track,
the stop positions correspond to loading ports for loading the transport vehicles,
the branch tracks connect to the second main track via branch points different from each other,
the certain section includes a first section, which is a section upstream of the stop position in each of the branch tracks, and
the departure control prohibits departure of the transport vehicle stopped at the stop position of one of the branch tracks when the transport vehicle is not present in the first section of one of the branch tracks and the transport vehicle scheduled to enter the first section from the second main track is not present.

### <Invention 3>

The transport system according to Invention 2, in which
in the first section, an unloading port for unloading the load from the transport vehicle is disposed along the track, and
the departure control prohibits departure of the transport vehicle stopped at the stop position of one of the branch tracks when the transport vehicle having already unloaded to the unloading port is not present in the first section of one of the branch tracks.

### <Invention 4>

The transport system according to any one of Inventions 1 to 3, in which
the certain section includes a second section, which is a section to the confluence point most downstream from the stop positions of the branch tracks in the track, and
the departure control prohibits departure of all the transport vehicles stopped at the respective stop positions of the branch tracks when another transport vehicle other than the transport vehicles is present in the second section.

### <Invention 5>

The transport system according to any one of Inventions 1 to 4, in which the departure control
causes the transport vehicles stopped at the respective stop positions of the branch tracks to depart at a timing repeated at a fixed cycle for each of the branch tracks and,
for the transport vehicle the departure in a certain cycle of which has been prohibited, determines again whether departure in the next cycle is prohibited.

### <Invention 6>

The transport system according to Invention 5, in which the departure control, for the transport vehicle the departure of which has been prohibited over certain cycles, permits departure in the next cycle.

### Reference Signs List

1 ... transport system
3 ... track
4 ... delivery port
10, 10a, 10b, 10X ... transport vehicle
20 ... controller
31 ... main track (first main track)
32 ... main track (second main track)
33a to 33d ... first branch track (branch track)
34a to 34d ... second branch track
35a to 35d ... confluence point
36a to 36d ... branch point
41 ... unloading port
42 ... loading port
L ... load
R ... specific section
Z ... certain section
Z1 ... first section
Z2 ... second section

## Claims

1. A transport system comprising:
a plurality of transport vehicles configured to travel along a track and transport a load; and
a controller configured to control traveling of the transport vehicles,
the track having a first main track and a plurality of branch tracks connecting to the first main track via confluence points different from each other,
the controller executing departure control that causes the transport vehicles stopped at respective stop positions of the branch tracks to depart toward the first main track for each of the branch tracks,
the departure control prohibiting, in accordance with whether the transport vehicle is present in a certain section on the track, departure of at least one of the transport vehicles stopped at the respective stop positions of the branch tracks.

2. The transport system according to claim 1, wherein
the track has a second main track,
the stop positions correspond to loading ports for loading the transport vehicles,
the second main track branches off to the branch tracks via branch points different from each other,
the certain section includes a first section, which is a section upstream of the stop position in each of the branch tracks, and
the departure control prohibits departure of the transport vehicle stopped at the stop position of one of the branch tracks when the transport vehicle is not present in the first section of one of the branch tracks and the transport vehicle scheduled to enter the first section from the second main track is not present.

3. The transport system according to claim 2, wherein
in the first section, an unloading port for unloading the load from the transport vehicle is disposed along the track, and
the departure control prohibits departure of the transport vehicle stopped at the stop position of one of the branch tracks when the transport vehicle having already unloaded to the unloading port is not present in the first section of one of the branch tracks.

4. The transport system according to any one of claims 1 to 3, in which
the certain section includes a second section, which is a section to the confluence point most downstream from the stop positions of the branch tracks in the track, and
the departure control prohibits departure of all the transport vehicles stopped at the respective stop positions of the branch tracks when another transport vehicle other than the transport vehicles is present in the second section.

5. The transport system according to any one of claims 1 to 3, wherein the departure control
causes the transport vehicles stopped at the respective stop positions of the branch tracks to depart at a timing repeated at a fixed cycle for each of the branch tracks and,
for the transport vehicle the departure in a certain cycle of which has been prohibited, determines again whether departure in the next cycle is prohibited.

6. The transport system according to claim 5, wherein the departure control, for the transport vehicle the departure of which has been prohibited over certain cycles, permits departure in the next cycle.
